# EUROPÄISCHE PATENTSCHRIFT

(11) **EP 3 377 856 B1**
(45) Veröffentlichungstag und Bekanntmachung des Hinweises auf die Patenterteilung: **18.09.2019**
(21) Anmeldenummer: 16794996.5
(22) Anmeldetag: 09.11.2016
(51) Int. Cl.: G01C 19/5747, G01C 19/5712

(54) **MIKROMECHANISCHER DREHRATENSENSOR UND BETRIEBSVERFAHREN DESSELBEN**
MICROMECHANICAL YAW RATE SENSOR AND METHOD FOR OPERATING SAME
CAPTEUR DE VITESSE DE LACET MICROMÉCANIQUE ET SON PROCÉDÉ DE FONCTIONNEMENT

(30) Priorität: 20.11.2015 DE 102015222943; 28.07.2016 DE 102016213877
(43) Veröffentlichungstag der Anmeldung: 26.09.2018
(73) Patentinhaber: Robert Bosch GmbH, 70442 Stuttgart (DE)
(72) Erfinder: NEUL, Reinhard, 70567 Stuttgart (DE); OHMS, Torsten, 71665 Vaihingen/Enz-Aurich (DE); MAUL, Robert, 75181 Pforzheim (DE); HATTASS, Mirko, 70191 Stuttgart (DE); HOEPPNER, Christian, 70197 Stuttgart (DE); PRUETZ, Odd-Axel, 72622 Nuertingen (DE); SCHMIDT, Benjamin, 70499 Stuttgart (DE); SCHEBEN, Rolf, 72762 Reutlingen (DE); HEUCK, Friedjof, 70193 Stuttgart (DE)
(86) Internationale Anmeldenummer: PCT/EP2016/077041
(87) Internationale Veröffentlichungsnummer: WO 2017/084918

(56) Entgegenhaltungen:
- DE-A1-102011 006 394
- US-A1- 2012 125 101
- US-B2- 8 833 162

## Beschreibung

### Stand der Technik

Die vorliegende Erfindung bezieht sich auf einen mikromechanischen Drehratensensor, insbesondere auf einen Drehratensensor mit schwingenden Coriolis-Elementen. Unter einem weiteren Gesichtspunkt bezieht sich die Erfindung auf ein Verfahren zum Betreiben eines derartigen mikromechanischen Drehratensensors.

Mikromechanische Drehratensensoren mit Coriolis-Elementen, d. h. mit schwingend angetriebenen Massen, die bei einer Drehung des Drehratensensors eine Auslenkung aufgrund der auf die Massen wirkenden Coriolis-Kraft erfahren, sind allgemein bekannt. So weist ein bekannter mikromechanischer Drehratensensor einen Schwingkörper auf, der sich in einer x-y-Ebene erstreckt und in eine lineare Oszillation entlang einer in dieser Ebene liegenden räumlichen Achse (z.B. x-Achse) versetzt wird. Bei einer Drehung um eine Drehachse (z-Achse), die senkrecht auf der Ebene steht, bewirkt die Corioliskraft eine Verschiebung des Schwingkörpers in einer Richtung (y-Achse), die in der Ebene senkrecht auf der Oszillationsachse (x-Achse) steht. Diese Verschiebung kann mit Hilfe von Messelektroden kapazitiv detektiert und ausgewertet werden.

Ein solcher Drehratensensor umfasst, wie in der DE 10 2011 006 394 A1 offenbart, z.B. ein erstes Coriolis-Element und ein zweites Coriolis-Element sowie ein Kopplungsglied, welches das erste Coriolis-Element und das zweite Coriolis-Element zu einer antiparallelen Antriebsmode mechanisch miteinander koppelt. Die Coriolis-Elemente sind von U-förmigen, miteinander gekoppelten Antriebselementen umgeben, die auf den jeweils zugewandten Seiten durchbrochen sind und an den Schenkeln nach außen abstehende bewegliche Elektroden aufweisen, die kammartig in feststehende Elektroden greifen, die durch Lagerblöcke fest mit einem Substrat verbunden sind.

Auch der in der US 8,833,162 B2 beschriebene Drehratensensor umfasst ein erstes Coriolis-Element und ein zweites Coriolis-Element, wobei ein Kopplungsglied das erste Coriolis-Element und das zweite Coriolis-Element zu einer antiparallelen Antriebsmode koppelt. Ein entlang dem ersten Coriolis-Element angeordneter Antriebsbalken ist über eine Feder an das erste Coriolis-Element gekoppelt. Von dem Antriebsbalken weg erstreckt sich ein Antriebselektrodenträger, welcher eine Vielzahl von parallel zum Antriebsbalken verlaufenden Antriebselektroden trägt, in einer zu dem ersten Coriolis-Element zugewandten Richtung.

Des Weiteren beschreibt die US 2012/0125101 A1 einen Drehratensensor mit einem einzigen Coriolis-Element, welches von einem Antriebsrahmen umgeben ist. Von dem Antriebsrahmen nach Außen erstrecken sich Antriebselektrodenträger, welche mit Antriebselektroden bestückt sind.

Für viele Anwendungen ist es wünschenswert, den vom Drehratensensor benötigten Bauraum zu reduzieren.

### Offenbarung der Erfindung

Die vorliegende Erfindung schafft einen mikromechanischen Drehratensensor mit den Merkmalen des Patentanspruchs 1 und ein Verfahren zum Betreiben eines Mikromechanischen Drehratensensors mit den Merkmalen des Patentanspruchs 8.

### Vorteile der Erfindung

Dadurch, dass der Antriebselektrodenträger sich vom Antriebsbalken in der zum ersten Coriolis-Element entgegengesetzten Richtung erstreckt, kann das Coriolis-Element angetrieben werden, ohne von Antriebselementen umgeben zu sein, die Antriebselektroden tragen. Somit können insbesondere sich senkrecht zum Antriebsbalken erstreckende Seiten des Coriolis-Elements frei bleiben, was eine besonders kompakte Bauweise des Drehratensensors in der zum Antriebsbalken parallelen Richtung ermöglicht. Zudem kann entlang der dem ersten Coriolis-Element abgewandten Seite des Antriebsbalkens aufgrund der Abwesenheit des Coriolis-Elements an dieser Seite eine größere Anzahl von Antriebselektrodenträgern vorgesehen werden, deren Wirkungen sich addieren, sodass jeder einzelne Antriebselektrodenträger nur eine geringe Anzahl von Antriebselektroden zu tragen und eine geringe Länge aufzuweisen braucht. Daher ermöglicht der erfinderische Drehratensensor eine kompakte Bauweise auch in der zum Antriebsbalken senkrechten Richtung.

Vorzugsweise umfasst das Kopplungsglied einen Wippbalken, der sich senkrecht zum ersten Antriebsbalken neben dem ersten und zweiten Coriolis-Element erstreckt sowie mit dem ersten und zweiten Coriolis-Element jeweils über einen Kopplungsfederstab federnd gekoppelt ist, und einen Wippfederstab, der den Wippbalken federnd mit einem zwischen dem ersten und zweiten Coriolis-Element gelegenen Verankerungspunkt verbindet. Diese Ausführung ermöglicht es, neben der Kopplung zu der antiparallelen Antriebsmode, zugleich die Coriolis-Elemente zu einer antiparallelen Detektionsmode in der Haupterstreckungsebene des Drehratensensors, in der der Antriebsbalken und die Coriolis-Elemente angeordnet sind, sowie weiter zu einer antiparallelen Detektionsmode aus der Haupterstreckungsebene heraus zu koppeln. Auf diese Weise kann der Drehratensensor bei äußerst kompakter Bauweise eine jeweilige Drehrate für Drehungen um eine erste Drehachse, die senkrecht zur Haupterstreckungsebene verläuft, und um eine zweite Drehachse, die in der Haupterstreckungsebene senkrecht zum Antriebsbalken verläuft, detektieren.

Gemäß einer bevorzugten Weiterbildung erstrecken die ersten Antriebselektroden sich jeweils in Richtung eines nächstgelegenen Endes des ersten Antriebsbalkens. Auf diese Weise wird der Antriebsbalken im Betrieb auf Zug belastet, was eine größere mechanische Stabilität ermöglicht.

Gemäß einer bevorzugten Weiterbildung ist der erste Antriebsbalken mit an den jeweiligen Enden befestigten Aufhängefedern federnd aufgehängt. Auf einfache Weise wird so eine mechanische Aufhängung des Antriebsbalkens bewirkt und ferner ermöglicht, dass der Antriebsbalken im Betrieb eine besonders regelmäßige, durch die Federkonstante der Federn bestimmte Schwingbewegung ausführt. Vorzugsweise sind die Aufhängefedern näher an der zum ersten Coriolis-Element entgegengesetzten Seite am Antriebsbalken befestigt. An dieser Seite befindet sich der Antriebselektrodenträger, sodass die Aufhängung vorteilhaft in der Nähe des Schwerpunkts erfolgt.

Gemäß einer bevorzugten Weiterbildung sind ferner ein Rotationsschwinger, der an der dem ersten Coriolis-Element zugewandten Seite des ersten Antriebsbalkens neben dem ersten und zweiten Coriolis-Element angeordnet ist, sowie eine dritte Feder, die den Rotationsschwinger federnd an den ersten Antriebsbalken koppelt, vorgesehen. Dies ermöglicht, mittels des Rotationsschwingers eine Drehung um noch eine weitere Drehachse zu detektieren. Da der Rotationsschwinger an der dem ersten Coriolis-Element zugewandten Seite des Antriebsbalkens neben den Coriolis-Elementen angeordnet ist, kann der Antriebsbalken sich innerhalb eines insgesamt geringen Bauraums entlang sowohl der Coriolis-Elemente als auch des Rotationsschwingers erstreckend besonders lang ausgebildet werden, was die Antriebsbewegung weiter stabilisiert.

Gemäß einer bevorzugten Weiterbildung umfasst der mikromechanische Drehratensensor ferner einen zweiten Antriebsbalken, der parallel zum ersten Antriebsbalken entlang der vom ersten Coriolis-Element abgewandten Seite des zweiten Coriolis-Elements angeordnet und über eine zweite Feder an das zweite Coriolis-Element gekoppelt ist. Auf diese Weise kann der Antrieb in besonders ausgeglichener Weise von zwei Seiten erfolgen, während über die erste Feder, das erste Coriolis-Element, das Kopplungsglied, das zweite Coriolis-Element und die zweite Feder auch eine den Antrieb stabilisierende mechanische Kopplung der Antriebsbalken untereinander erreicht wird. Vorzugsweise ist ferner ein zweiter Antriebselektrodenträger vorgesehen, der sich vom zweiten Antriebsbalken in der zum ersten Coriolis-Element entgegengesetzten Richtung erstreckt und eine Vielzahl von parallel zum zweiten Antriebsbalken verlaufenden zweiten Antriebselektroden trägt. Somit können die Antriebsbalken für einen besonders ausgeglichenen Antrieb symmetrisch ausgeführt werden, während die besonders kompakte Bauweise des Drehratensensors in der zum Antriebsbalken parallelen Richtung bewahrt bleibt.

### Kurze Beschreibung der Zeichnungen

- Figur 1: Schematische Draufsicht auf einen mikromechanischen Drehratensensor gemäß einer Ausführungsform der Erfindung, wobei feststehende Teile nicht gezeigt sind.
- Figur 2: Flussdiagramm eines Betriebsverfahrens für einen mikromechanischen Drehratensensor gemäß einer Ausführungsform.

Sofern nicht ausdrücklich anders erwähnt, beziehen sich gleiche Bezugszeichen in den Figuren auf gleiche oder äquivalente Elemente.

### Ausführungsformen der Erfindung

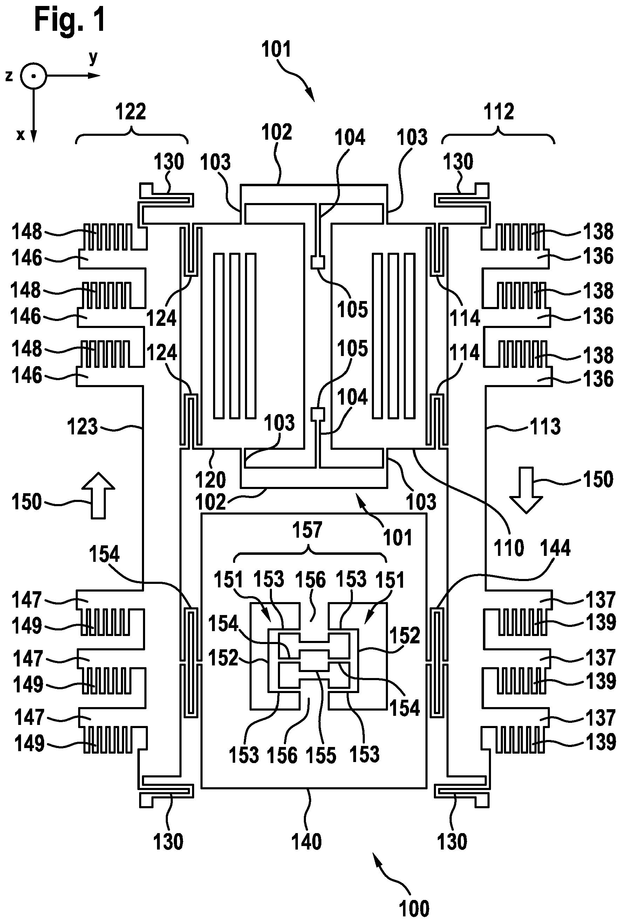

Figur 1 zeigt einen Drehratensensor 100 gemäß einer beispielhaften Ausführungsform der Erfindung. Bei Figur 1 handelt es sich um eine Aufsicht auf ein nicht näher dargestelltes Substrat mit einer Haupterstreckungsebene (x-y-Ebene), in der zwischen einem ersten Antriebsbalken 113 und einem zweiten Antriebsbalken 123 ein erstes Coriolis-Element 110, ein zweites Coriolis-Element 120 und ein Rotationsschwinger 140 angeordnet sind. Wie in der linken oberen Ecke von Figur 1 graphisch angegeben ist, weist in Figur 1 die x-Richtung von oben nach unten, die y-Richtung von links nach rechts und die z-Richtung aus der Zeichenebene heraus zum Betrachter.

Das erste und zweite Coriolis-Element 110, 120 sind als rechteckige, rahmenförmige Strukturen gleicher Form und Größe ausgebildet, die mit ihren Langseiten parallel zur x-Richtung ausgerichtet und nebeneinander angeordnet sind, sodass eine Langseite des ersten Coriolis-Elements 110 und eine Langseite des zweiten Coriolis-Elements 120 durch einen Spalt beabstandet einander gegenüberliegen, wobei die Kurzseiten der Coriolis-Elemente 110, 120 paarweise miteinander fluchten. Die Rahmenstruktur der Coriolis-Elemente 110, 120 ergibt sich daraus, dass sie in der Nähe der voneinander abgekehrten Langseiten jeweils einen gitterartigen Gewichtsverringerungsbereich aufweisen, in dem längs verlaufende, nur durch dünne Stege voneinander getrennte Aussparungen gebildet sind.

An den beiden Paaren ihrer miteinander fluchtenden, benachbarten Kurzseiten sind die Coriolis-Elemente 110, 120 durch zwei spiegelsymmetrische Kopplungsglieder 101 beweglich miteinander gekoppelt. Jedes Kopplungsglied 101 umfasst einen Wippbalken 102, der sich neben dem ersten und zweiten Coriolis-Element 110, 120 parallel zu den miteinander fluchtenden Kurzseiten erstreckt, wobei je ein Ende des Wippbalkens 102 der Mitte einer Kurzseite gegenüberliegt. An den beiden Enden des Wippbalkens 102 weist das Kopplungsglied 101 jeweils einen Kopplungsfederstab 103 auf, der das Ende des Wippbalkens 102 auf kürzestem Wege mit der Mitte der gegenüberliegenden Kurzseite des entsprechenden Coriolis-Elements federnd verbindet. Ferner beinhaltet das Kopplungsglied 101 einen Wippfederstab 104, der sich von der Mitte des Wippbalkens 102, die dem Spalt zwischen den Coriolis-Elementen 110, 120 gegenüberliegt, bis zu einem im Spalt gelegenen Substratverankerungspunkt 105 erstreckt, um den Wippbalken 102 federnd mit dem Substrat zu verbinden.

Die einzelnen Kopplungsglieder 101 weisen somit insgesamt die Gestalt eines "E" auf, wobei der Wippfederstab 104 in der vorliegenden Ausführungsform länger als die Kopplungsfederstäbe 103 ausgebildet ist. Beispielsweise hat der Wippfederstab 104 die zweibis dreifache Länge der Kopplungsfederstäbe 103.

Gegenüber der der Langseite des ersten Coriolis-Elements 110, die vom zweiten Coriolis-Element 120 entfernt gelegen ist, erstreckt sich in der x-Richtung der erste Antriebsbalken 113. Die beiden Ecken des Coriolis-Elements 110 an dieser Langseite sind mit je einer ersten Feder 114 federnd an den Antriebsbalken 113 gekoppelt. Der Antriebsbalken 113 selbst ist an seinen beiden Enden mit je einer Aufhängefeder 130, die jeweils näher zur von den Coriolis-Elementen 110, 120 abgewandten Seite des ersten Antriebsbalkens 113 angebunden ist, derart federnd an einem mit dem Substrat fest verbundenen Substratverankerungspunkt aufgehängt, dass er in der x-Richtung schwingend beweglich ist.

An der von den Coriolis-Elementen 110, 120 abgewandten Seite des ersten Antriebsbalkens 113 sind eine Vielzahl erster Antriebselektrodenträger 136, 137 ausgebildet, die sich vom ersten Antriebsbalken 113 in Richtung der zu den Coriolis-Elementen 110, 120 entgegengesetzten Seite abstrecken und im Wesentlichen parallel zur y-Richtung verlaufen. Jeder der ersten Antriebselektrodenträger 136, 137 trägt eine Vielzahl von ersten Antriebselektroden 138, 139, die parallel zur x-Richtung ausgedehnt sind. In der vorliegenden Ausführungsform sei beispielhaft angenommen, dass der Antriebsbalken 113 einschließlich der Antriebselektrodenträger 136, 137 und der Antriebselektroden 138, 139 eine konstante Dicke in der z-Richtung aufweist, die größer als die Breite der Antriebselektroden 138, 139 in der y-Richtung ist und z.B. gleich der Breite des Antriebsbalkens 113 in der y-Richtung sein kann. Damit weisen die einzelnen Antriebselektroden 138, 139 eine flächenhafte Ausdehnung parallel zur x- und z-Richtung auf.

In der vorliegenden Ausführungsform sind entlang des ersten Antriebsbalkens 113 mehrere erste Antriebselektrodenträger 136, 137 vorgesehen, wobei eine Hälfte der Antriebselektrodenträger 136 zu einem Ende des ersten Antriebsbalkens 113 hin gruppiert angeordnet ist und die andere Hälfte der Antriebselektrodenträger 137 zum anderen Ende des ersten Antriebsbalkens 113 hin gruppiert angeordnet ist. Zwischen den beiden Gruppen befindet sich in der Mitte des ersten Antriebsbalkens 113 ein von Antriebselektrodenträgern freier Abschnitt. Die jeweiligen Antriebselektroden 138, 139 an den beiden Gruppen von Antriebselektrodenträgern 136, 137 weisen jeweils zur Seite des nächstgelegenen Endes des ersten Antriebsbalkens 113.

Spiegelsymmetrisch zum ersten Antriebsbalken 113 erstreckt sich gegenüber der Langseite des zweiten Coriolis-Elements 120, die vom ersten Coriolis-Element 110 entfernt gelegen ist, der zweite Antriebsbalken 123. Die beiden Ecken des zweiten Coriolis-Elements 120 an dieser Langseite sind mit je einer zweiten Feder 124 federnd an den zweiten Antriebsbalken 123 gekoppelt. An der von den Coriolis-Elementen 110, 120 abgewandten Seite des zweiten Antriebsbalkens 123 sind eine Vielzahl zweiter Antriebselektrodenträger 146, 147 ausgebildet, die sich vom zweiten Antriebsbalken 123 in der zu den Coriolis-Elementen 110, 120 entgegengesetzten Richtung abstrecken. Jeder zweite Antriebselektrodenträger 146, 147 trägt eine Vielzahl von ersten Antriebselektroden 148, 149. Wegen der Spiegelsymmetrie der aus dem ersten Antriebsbalken 113, den ersten Federn 114 und dem ersten Coriolis-Element 110 bestehenden Anordnung mit der aus dem zweiten Antriebsbalken 123, den zweiten Federn 124 und dem zweiten Coriolis-Element 120 bestehenden Anordnung wird zu weiteren Details auf die obigen Ausführungen zum ersten Antriebsbalken 113 verwiesen.

In der vorliegenden Ausführungsform fluchten die beiden Antriebsbalken 113, 123 jeweils bündig mit einem Ende der Langseiten der Coriolis-Elemente 110, 120, ragen dagegen über das andere Ende hinaus, wobei in dem neben den Coriolis-Elementen 110, 120 gebildeten weiteren Raum zwischen den Antriebsbalken 113, 123 der Rotationsschwinger 140 angeordnet ist. Mit einer dritten und vierten Feder 144, 145 ist der Rotationsschwinger 140 an den ersten beziehungsweise zweiten Arbeitsbalken 113, 123 gekoppelt. In der vorliegenden Ausführungsform weist der Rotationsschwinger 140 eine rechteckige Umrissgestalt auf, deren Langseiten nur geringfügig länger als die Kurzseiten gebildet sind und jeweils zu einem der Antriebsbalken 113, 123 parallel verlaufend diesem unter Bildung eines Spaltes gegenüberliegen. Dies ermöglicht eine besonders kompakte Bauweise des Drehratensensors und Ausnutzung des Bauraums. In alternativen Ausführungsformen kann der Rotationsschwinger 140 z.B. quadratisch, kreisförmig oder elliptisch gestaltet sein.

An einer Achsposition des Rotationsschwingers 140, die sich nahe des geometrischen Zentrums des Rotationsschwingers 140 befindet, ist ein Rotationsschwinglager 157 gebildet, welches den Rotationsschwinger 140 schwingend drehbar um eine in der z-Richtung durch einen Substratverankerungspunkt 155 durch die Achsposition verlaufende Rotationsschwingachse abstützt. Angemerkt wird, dass in alternativen Ausführungsformen die Achsposition sich auch exakt im geometrischen Zentrum des Rotationsschwingers 140 oder einer anderen Position befinden kann, sofern der Rotationsschwinger 140 eine schwingende Drehbewegung um die durch die Achsposition verlaufende Rotationsschwingachse ausführen kann. Vorzugsweise liegt der Schwerpunkt des Rotationsschwingers 140 an der Achsposition. Das Rotationsschwinglager 157 umfasst eine rechteckigen Aussparung im Rotationsschwinger 140, innerhalb derer sich der Substratverankerungspunkt 155 befindet. Zwei Stege 156 erstrecken sich von zwei gegenüberliegenden Rändern der Aussparung in Richtung des Substratverankerungspunkts 155, wobei zwischen dem distalen Ende jedes Stegs 156 und dem Substratverankerungspunkt 155 jeweils ein Abstand verbleibt.

In den zu beiden Seiten der Stege 156 verbleibenden Bereichen der Aussparung weist das Rotationsschwinglager 157 jeweils ein Lagerungsglied 151 auf, welches die Stege 156 und den Substratverankerungspunkt 155 miteinander verbindet. Jedes Lagerungsglied 151 umfasst einen Wippbalken 152, der sich neben den Stegen 156 und dem Substratverankerungspunkt 155 parallel zu den miteinander fluchtenden Stegen 156 erstreckt, wobei je ein Ende des Wippbalkens 152 dem Ende eines Steges 156 gegenüberliegt. An den beiden Enden des Wippbalkens 152 weist das Lagerungsglied 151 jeweils einen Lagerungsfederstab 153 auf, der das Ende des Wippbalkens 152 auf kürzestem Wege mit dem zugehörigen Steg 156 federnd verbindet. Ferner beinhaltet das Lagerungsglied 151 einen Wippfederstab 154, der sich von der Mitte des Wippbalkens 152, die dem Substratverankerungspunkt 155 gegenüberliegt, bis zum Substratverankerungspunkt 155 erstreckt, um den Wippbalken 152 federnd mit dem Substrat zu verbinden. Die einzelnen Lagerungsglieder 151 weisen somit, ähnlich wie die Kopplungsglieder 101, 102 insgesamt die Gestalt eines "E" auf, wobei der Wippfederstab 154 und die Lagerungsfederstäbe 153 in der vorliegenden Ausführungsform gleich lang ausgebildet sind.

Im Betrieb des mikromechanischen Drehsensors 100 werden die Antriebselektroden 138, 139, 148, 149 und zugehörige statische Elektroden (nicht gezeigt), die gegenüber dem Substrat unbeweglich sind und sich mit den Antriebselektroden 138, 139, 148, 149 jeweils kämmen, derart koordiniert mit unterschiedlichen, zeitlich wechselnden elektrischen Spannungen beaufschlagt, dass die Antriebsbalken 113, 123 in eine antiparallele Antriebsmode 150 versetzt werden, in der sie entlang der x-Achse eine zueinander um 180° phasenversetzte Schwingbewegung ausführen.

Beispielsweise werden, während die Antriebsbalken 113 mit den Antriebselektroden 138, 139, 148, 149 auf einem konstantem Massepotential gehalten werden, mittels einer elektronischen Steuervorrichtung (nicht gezeigt) zunächst die statischen Elektroden, die sich mit den zur Seite der Coriolis-Elemente 110, 120 (in Figur 1 nach oben) weisenden Antriebselektroden 138 am ersten Antriebsbalken 113 kämmen, und die statischen Elektroden, die sich mit den zur entgegengesetzten Seite des Rotationsschwingers 140 (in Figur 1 nach unten) weisenden Antriebselektroden 149 am zweiten Antriebsbalken 123 kämmen, mit einer elektrischen Spannung gegenüber Masse beaufschlagt, sodass der erste Antriebsbalken 113 durch die elektrostatischen Kräfte in der in Figur 1 nach oben weisenden Richtung beschleunigt wird, während der zweite Antriebsbalken 123 durch die elektrostatischen Kräfte in der in Figur 1 nach unten weisenden Richtung beschleunigt wird. Anschließend wird die angelegte Spannung abgeschaltet, worauf die Antriebsbalken 113, 123 durch die Rückstellkräfte der Aufhängefedern 130 verzögert und wieder in Richtung der Ausgangsstellung beschleunigt werden.

Nachfolgend werden die statischen Elektroden, die sich mit den in Figur 1 nach oben weisenden Antriebselektroden 148 am zweiten Antriebsbalken 123 kämmen, und die statischen Elektroden, die sich mit den in Figur 1 nach unten weisenden Antriebselektroden 139 am ersten Antriebsbalken 113 kämmen, mit einer elektrischen Spannung gegenüber Masse beaufschlagt, sodass der erste Antriebsbalken 113 durch die elektrostatischen Kräfte in der in Figur 1 nach unten weisenden Richtung beschleunigt wird, während der zweite Antriebsbalken 123 durch die elektrostatischen Kräfte in der in Figur 1 nach oben weisenden Richtung beschleunigt wird. Anschließend wird die angelegte Spannung wieder abgeschaltet, worauf die Antriebsbalken 113, 123 durch die Rückstellkräfte der Aufhängefedern 130 zunächst verzögert und dann in Richtung der Ausgangsstellung beschleunigt werden.

Hierbei kann die obige Ansteuerung in vorteilhafter Weise mit einer zeitlichen Periode wiederholt werden, die im Wesentlichen mit der Eigenfrequenz der antiparallelen Schwingungsmode 150 übereinstimmt, in welcher eine aus dem ersten Antriebsbalken 113, den ersten Antriebselektrodenträgern 136, 137 und den ersten Antriebselektroden 138, 139 bestehende erste Antriebsmasse 112 und eine aus dem zweiten Antriebsbalken 123, den zweiten Antriebselektrodenträgern 146, 147 und den zweiten Antriebselektroden 148, 149 bestehende zweite Antriebsmasse 112 gegenphasig entlang der x-Achse schwingen. In dieser Antriebsmode 150 führt das erste Coriolis-Element 110 aufgrund der Ankopplung über die erste Feder 114 eine Schwingbewegung aus, die zur ersten Antriebsmasse 112 einen konstanten Winkel phasenversetzt ist (z.B. gleichphasig ist), während das zweite Coriolis-Element aufgrund der Ankopplung über die zweite Feder 124 eine Schwingbewegung ausführt, die zur zweiten Antriebsmasse 112 - z.B. bei symmetrischer Ausbildung und Ansteuerung wie in der vorliegenden Ausführungsform - um ebenfalls den konstanten Winkel phasenversetzt ist. Dies bedeutet, dass das erste Coriolis-Element 110 und das zweite Coriolis-Element 120 eine antiparallele Schwingbewegung in zum Antriebsbalken paralleler Richtung ausführen, welche durch die mechanische Kopplung über die Kopplungsglieder 101, 102 zusätzlich stabilisiert wird.

In der obigen antiparallelen Antriebsmode 150 wird ferner der Rotationsschwinger 140 aufgrund der Ankopplung über die dritte und vierte Feder 144, 145 in eine schwingende Drehbewegung um die in z-Richtung durch den Substratverankerungspunkt 155 des Rotationsschwinglagers 157 verlaufende Achse versetzt. Über einerseits die dritte Feder 144, den Rotationsschwinger 140 und die vierte Feder 154 sowie andererseits die erste Feder 114, das erste Coriolis-Element 110, die Kopplungsglieder 101, das zweite Coriolis-Element 120 und die zweite Feder 124 ergibt sich eine mechanische Kopplung zwischen den Schwingbewegungen der ersten und zweiten Antriebsmasse 112, 122, welche die antiparallele Antriebsmode 150 stabilisiert.

Wenn der Drehratensensor 100 bei fortgesetzter Ausführung der antiparallelen Antriebsmode 150 um die x-Achse gedreht wird, wirkt auf den Rotationsschwinger 140 ein Drehmoment, das den Rotationsschwinger um die durch die dritte und vierte Feder 144 sowie die Wippfederstäbe 154 der Lagerungsglieder 151 gehende Achse aus der Haupterstreckungsebene auslenkt.

Wird der Drehratensensor 100 um die y-Achse gedreht, wirken auf die Coriolis-Elemente 110, 120 Kräfte, die diese in zueinander entgegengesetzter Richtung aus der Haupterstreckungsebene auslenken. Dabei erfolgt durch Verkippen der Wippbalken 102 der Kopplungsglieder 101 um die zugehörigen Wippfederstäbe 104 eine stabilisierende mechanische Kopplung zwischen den Auslenkungen der beiden Coriolis-Elemente 110, 120. Wird der Drehratensensor 100 um die z-Achse gedreht, wirken auf die Coriolis-Elemente 110, 120 Kräfte, die diese in zueinander entgegengesetzter Richtung parallel zur y-Achse auslenken. Dabei erfolgt durch Biegen Kopplungsfederstäbe 103 eine stabilisierende mechanische Kopplung zwischen den Auslenkungen der beiden Coriolis-Elemente 110, 120. Eine Detektion der Auslenkungen der Coriolis-Elemente 110, 120 und des Rotationsschwingers kann in den obigen Fällen kann jeweils über Kapazitätsveränderungen an geeignet positionierten Messelektroden (nicht gezeigt) erfolgen.

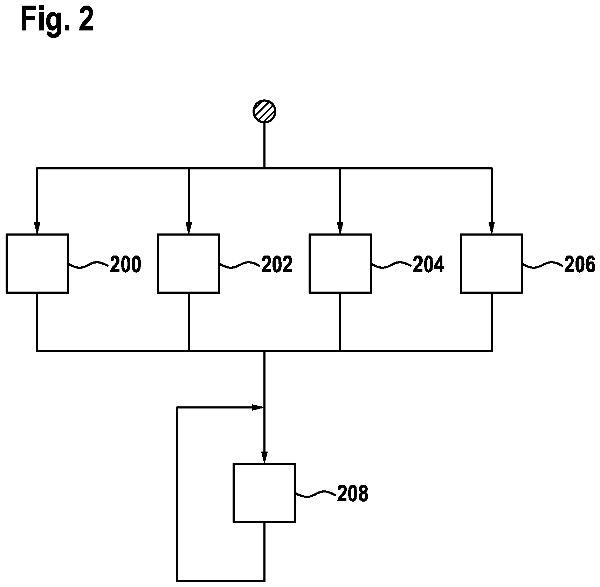

Figur 2 zeigt ein Flussdiagramm für ein Verfahren zum Betreiben eines mikromechanischen Drehratensensors mit einem ersten und zweiten Coriolis-Element, die nebeneinander angeordnet und durch ein Kopplungsglied zu einer antiparallelen Antriebsmode gekoppelt sind, wie z.B. des vorstehend beschriebenen Drehratensensors 100 aus Figur 1.

In Schritt 200 bis 206 wird der Drehratensensor mittels eines mikromechanischen Prozesses hergestellt. In Schritt 200 wird ein erster Antriebsbalken vorgesehen, der entlang dem ersten Coriolis-Element angeordnet und über eine erste Feder an das erste Coriolis-Element gekoppelt ist. In Schritt 202 wird ein erster Antriebselektrodenträger, der sich vom ersten Antriebsbalken in der zum ersten Coriolis-Element entgegengesetzten Richtung erstreckt und eine Vielzahl von parallel zum ersten Antriebsbalken verlaufenden ersten Antriebselektroden trägt vorgesehen. In Schritt 204 wird ein zweiter Antriebsbalken vorgesehen, der parallel zum ersten Antriebsbalken entlang der vom ersten Coriolis-Element abgewandten Seite des zweiten Coriolis-Elements angeordnet und über eine zweite Feder an das zweite Coriolis-Element gekoppelt ist. In Schritt 206 wird ein zweiter Antriebselektrodenträger vorgesehen, der sich vom zweiten Antriebsbalken in der zum ersten Coriolis-Element entgegengesetzten Richtung erstreckt und eine Vielzahl von parallel zum zweiten Antriebsbalken verlaufenden zweiten Antriebselektroden trägt. Angemerkt wird, dass in Figur 2 die Schritte 200 bis 206 zwar als gleichzeitig erfolgend dargestellt sind, in alternativen Ausführungsformen im Rahmen eines geeigneten mikromechanischen oder sonstigen Herstellungsverfahrens aber auch z.B. nacheinander durchgeführt werden können.

In Schritt 208 wird eine erste Vielzahl statischer Elektroden, die sich mit den ersten Antriebselektroden kämmen, und eine zweite Vielzahl statischer Elektroden, die sich mit den zweiten Antriebselektroden kämmen, durch Beaufschlagen mit einer elektrischen Spannung oder mehreren elektrischen Spannungen koordiniert angesteuert, um das erste und zweite Coriolis-Element in der antiparallelen Antriebsmode anzutreiben.

## Patentansprüche

1. Mikromechanischer Drehratensensor (100), aufweisend:
ein erstes Coriolis-Element (110);
einen ersten Antriebsbalken (113), welcher entlang dem ersten Coriolis-Element (110) angeordnet und über eine erste Feder (114) an das erste Coriolis-Element (110) gekoppelt ist;
einen ersten Antriebselektrodenträger (136, 137), welcher eine Vielzahl von parallel zum ersten Antriebsbalken (113) verlaufenden ersten Antriebselektroden (138, 139) trägt;
ein zweites Coriolis-Element (120), welches an der vom ersten Antriebsbalken (113) abgewandten Seite neben dem ersten Coriolis-Element (110) angeordnet ist; und
ein Kopplungsglied (101), welches das erste Coriolis-Element (110) und das zweite Coriolis-Element (120) zu einer antiparallelen Antriebsmode koppelt;
**dadurch gekennzeichnet, dass**
der erste Antriebselektrodenträger (136, 137) sich vom ersten Antriebsbalken (113) in der zum ersten Coriolis-Element (110) entgegengesetzten Richtung erstreckt.

2. Mikromechanischer Drehratensensor (100) nach Anspruch 1, wobei das Kopplungsglied (101) aufweist:
einen Wippbalken (102), welcher sich senkrecht zum ersten Antriebsbalken (113) neben dem ersten und zweiten Coriolis-Element (110, 120) erstreckt sowie mit dem ersten und zweiten Coriolis-Element (110, 120) jeweils über einen Kopplungsfederstab (103) federnd gekoppelt ist; und
einen Wippfederstab (104), welcher den Wippbalken (102) federnd mit einem zwischen dem ersten und zweiten Coriolis-Element (110, 120) gelegenen Verankerungspunkt (105) verbindet.

3. Mikromechanischer Drehratensensor (100) nach Anspruch 1 oder 2, wobei die Vielzahl der ersten Antriebselektroden (138, 139) sich in Richtung jeweils eines nächstgelegenen Endes des ersten Antriebsbalkens (113) erstreckt.

4. Mikromechanischer Drehratensensor (100) nach einem der vorhergehenden Ansprüche, wobei der erste Antriebsbalken (113) mit an den jeweiligen Enden, insbesondere auf der zum ersten Coriolis-Element (110) entgegengesetzten Seite, befestigten Aufhängefedern (130) federnd aufgehängt ist.

5. Mikromechanischer Drehratensensor (100) nach einem der vorhergehenden Ansprüche, ferner aufweisend:
einen Rotationsschwinger (140), welcher an der dem ersten Coriolis-Element (110) zugewandten Seite des ersten Antriebsbalkens (113) neben dem ersten und zweiten Coriolis-Element (110, 120) angeordnet ist; sowie
eine dritte Feder (144), welche den Rotationsschwinger (140) federnd an den ersten Antriebsbalken (113) koppelt.

6. Mikromechanischer Drehratensensor (100) nach einem der vorhergehenden Ansprüche, ferner aufweisend einen zweiten Antriebsbalken (123), welcher parallel zum ersten Antriebsbalken (113) entlang der vom ersten Coriolis-Element (110) abgewandten Seite des zweiten Coriolis-Elements (120) angeordnet und über eine zweite Feder (124) an das zweite Coriolis-Element (120) gekoppelt ist.

7. Mikromechanischer Drehratensensor (100) nach Anspruch 6, ferner aufweisend einen zweiten Antriebselektrodenträger (146, 147), welcher sich vom zweiten Antriebsbalken (123) in der zum ersten Coriolis-Element (110) entgegengesetzten Richtung erstreckt und eine Vielzahl von parallel zum zweiten Antriebsbalken (123) verlaufenden zweiten Antriebselektroden (148, 149) trägt.

8. Verfahren zum Betreiben eines Mikromechanischen Drehratensensors (100) mit einem ersten und zweiten Coriolis-Element (110, 120), welche nebeneinander angeordnet und durch ein Kopplungsglied (101) zu einer antiparallelen Antriebsmode gekoppelt sind, aufweisend folgende Schritte:
Vorsehen (200) eines ersten Antriebsbalkens (113), welcher entlang dem ersten Coriolis-Element (110) angeordnet und über eine erste Feder (114) an das erste Coriolis-Element (110) gekoppelt ist;
Vorsehen (202) eines ersten Antriebselektrodenträgers (136, 137), welcher eine Vielzahl von parallel zum ersten Antriebsbalken (113) verlaufenden ersten Antriebselektroden (138, 139) trägt; sowie
Ansteuern (208) einer ersten Vielzahl statischer Elektroden, welche sich mit den ersten Antriebselektroden kämmen, um das erste und zweite Coriolis-Element (110, 120) in der antiparallelen Antriebsmode anzutreiben;
**dadurch gekennzeichnet, dass**
der erste Antriebselektrodenträger (136, 137) sich vom ersten Antriebsbalken (113) in der zum ersten Coriolis-Element (110) entgegengesetzten Richtung erstreckt.

9. Verfahren nach Anspruch 8, ferner aufweisend folgende Schritte:
Vorsehen (204) eines zweiten Antriebsbalkens (123), welcher parallel zum ersten Antriebsbalken (113) entlang der vom ersten Coriolis-Element (110) abgewandten Seite des zweiten Coriolis-Elements (120) angeordnet und über eine zweite Feder (124) an das zweite Coriolis-Element (120) gekoppelt ist; sowie
Vorsehen (206) eines zweiten Antriebselektrodenträgers (146, 147), welcher sich vom zweiten Antriebsbalken (123) in der zum ersten Coriolis-Element (110) entgegengesetzten Richtung erstreckt und eine Vielzahl von parallel zum zweiten Antriebsbalken (123) verlaufenden zweiten Antriebselektroden (148, 149) trägt;
wobei der Schritt des Ansteuerns (208) das koordinierte Ansteuern einer zweiten Vielzahl statischer Elektroden umfasst, welche sich mit den zweiten Antriebselektroden (138, 139) kämmen.

## Claims

1. Micromechanical rate-of-rotation sensor (100), having:
a first Coriolis element (110);
a first drive beam (113), which is arranged along the first Coriolis element (110) and is coupled via a first spring (114) to the first Coriolis element (110);
a first drive electrode carrier (136, 137), which carries a multiplicity of first drive electrodes (138, 139) extending parallel to the first drive beam (113);
a second Coriolis element (120), which is arranged on the side facing away from the first drive beam (113), beside the first Coriolis element (110); and
a coupling element (101), which couples the first Coriolis element (110) and the second Coriolis element (120) to form an anti-parallel drive mode;
**characterized in that**
the first drive electrode carrier (136, 137) extends from the first drive beam (113) in the direction opposite to the first Coriolis element (110).

2. Micromechanical rate-of-rotation sensor (100) according to Claim 1, wherein the coupling element (101) has:
a rocking beam (102), which extends at right angles to the first drive beam (113), beside the first and second Coriolis element (110, 120), and is coupled to the first and second Coriolis element (110, 120) in a sprung manner in each case via a coupling spring rod (103); and
a rocking spring rod (104), which connects the rocking beam (102) in a sprung manner to an anchoring point (105) placed between the first and second Coriolis element (110, 120).

3. Micromechanical rate-of-rotation sensor (100) according to Claim 1 or 2, wherein the multiplicity of first drive electrodes (138, 139) each extend in the direction of a nearest end of the first drive beam (113).

4. Micromechanical rate-of-rotation sensor (100) according to one of the preceding claims, wherein the first drive beam (113) is suspended in a sprung manner by suspension springs (130) fixed to the respective ends, in particular on the side opposite to the first Coriolis element (110).

5. Micromechanical rate-of-rotation sensor (100) according to one of the preceding claims, further having:
a rotational vibrator (140), which is arranged on the side of the first drive beam (113) that faces the first Coriolis element (110), beside the first and second Coriolis element (110, 120); and
a third spring (144), which couples the rotational vibrator (140) in a sprung manner to the first drive beam (113) .

6. Micromechanical rate-of-rotation sensor (100) according to one of the preceding claims, further having a second drive beam (123), which is arranged parallel to the first drive beam (113) along the side of the second Coriolis element (120) that faces away from the first Coriolis element (110), and is coupled via a second spring (124) to the second Coriolis element (120).

7. Micromechanical rate-of-rotation sensor (100) according to Claim 6, further having a second drive electrode carrier (146, 147), which extends from the second drive beam (123) in the direction opposite to the first Coriolis element (110) and carries a multiplicity of second drive electrodes (148, 149) extending parallel to the second drive beam (123).

8. Method for operating a micromechanical rate-of-rotation sensor (100) having a first and second Coriolis element (110, 120) which are arranged beside one another and are coupled by a coupling element (101) to form an anti-parallel drive mode, having the following steps:
providing (200) a first drive beam (113), which is arranged along the first Coriolis element (110) and is coupled via a first spring (114) to the first Coriolis element (110);
providing (202) a first drive electrode carrier (136, 137), which carries a multiplicity of first drive electrodes (138, 139) extending parallel to the first drive beam (113); and
activating (208) a first multiplicity of static electrodes, which mesh with the first drive electrodes, in order to drive the first and second Coriolis element (110, 120) in the anti-parallel drive mode **characterized in that**
the first drive electrode carrier (136, 137) extends from the first drive beam (113) in the direction opposite to the first Coriolis element (110).

9. Method according to Claim 8, further having the following steps:
providing (204) a second drive beam (123), which is arranged parallel to the first drive beam (113) along the side of the second Coriolis element (120) that faces away from the first Coriolis element (110) and is coupled via a second spring (124) to the second Coriolis element (120); and
providing (206) a second drive electrode carrier (146, 147), which extends from the second drive beam (123) in the direction opposite to the first Coriolis element (110) and carries a multiplicity of second drive electrodes (148, 149) extending parallel to the second drive beam (123);
wherein the activation step (208) comprises the coordinated activation of a second multiplicity of static electrodes, which mesh with the second drive electrodes (138, 139).

## Revendications

1. Capteur de vitesse de rotation micromécanique (100), possédant :
un premier élément de Coriolis (110) ;
une première barre d'entraînement (113) qui est disposée le long du premier élément de Coriolis (110) et qui est accouplée au premier élément de Coriolis (110) par le biais d'un premier ressort (114) ;
un premier porte-électrodes d'entraînement (136, 137) qui porte une pluralité de premières électrodes d'entraînement (138, 139) s'étendant parallèlement à la première barre d'entraînement (113) ;
un deuxième élément de Coriolis (120) qui est disposé au niveau du côté à l'opposé de la première barre d'entraînement (113) à côté du premier élément de Coriolis (110) ; et
un organe d'accouplement (101) qui accouple le premier élément de Coriolis (110) et le deuxième élément de Coriolis (120) en un mode d'entraînement en tête-bêche ;
**caractérisé en ce que**
le premier porte-électrodes d'entraînement (136, 137) s'étend depuis la première barre d'entraînement (113) dans la direction opposée au premier élément de Coriolis (110) .

2. Capteur de vitesse de rotation micromécanique (100) selon la revendication 1, l'organe d'accouplement (101) possédant :
une barre basculante (102), laquelle s'étend perpendiculairement à la première barre d'entraînement (113) à côté du premier et du deuxième élément de Coriolis (110, 120) et est accouplée avec effet de ressort au premier et au deuxième élément de Coriolis (110, 120) respectivement par le biais d'une tige de ressort d'accouplement (103) ; et
une tige de ressort basculante (104) qui relie la barre basculante (102) avec effet de ressort à un point d'ancrage (105) se trouvant entre le premier et le deuxième élément de Coriolis (110, 120).

3. Capteur de vitesse de rotation micromécanique (100) selon la revendication 1 ou 2, la pluralité de premières électrodes d'entraînement (138, 139) s'étendant respectivement dans la direction d'une extrémité la plus proche de la première barre d'entraînement (113).

4. Capteur de vitesse de rotation micromécanique (100) selon l'une des revendications précédentes, la première barre d'entraînement (113) étant accrochée avec effet de ressort par des ressorts de suspension (130) fixés aux extrémités respectives, notamment sur le côté à l'opposé du premier élément de Coriolis (110).

5. Capteur de vitesse de rotation micromécanique (100) selon l'une des revendications précédentes, comprenant en outre :
un oscillateur à rotation (140), lequel est disposé au niveau du côté de la première barre d'entraînement (113) qui fait face au premier élément de Coriolis (110), à côté du premier et du deuxième élément de Coriolis (110, 120) ; et
un troisième ressort (144), lequel accouple l'oscillateur à rotation (140) à la première barre d'entraînement (113) avec effet de ressort.

6. Capteur de vitesse de rotation micromécanique (100) selon l'une des revendications précédentes, comprenant en outre une deuxième barre d'entraînement (123), laquelle est disposée parallèlement à la première barre d'entraînement (113) le long du côté du deuxième élément de Coriolis (120) à l'opposé du premier élément de Coriolis (110) et est accouplée au deuxième élément de Coriolis (120) par le biais d'un deuxième ressort (124).

7. Capteur de vitesse de rotation micromécanique (100) selon la revendication 6, comprenant en outre un deuxième porte-électrodes d'entraînement (146, 147), lequel s'étend depuis la deuxième barre d'entraînement (123) dans la direction opposée au premier élément de Coriolis (110) et porte une pluralité de deuxièmes électrodes d'entraînement (148, 149) qui s'étendent parallèlement à la deuxième barre d'entraînement (123).

8. Procédé pour faire fonctionner un capteur de vitesse de rotation micromécanique (100) comprenant un premier et un deuxième élément de Coriolis (110, 120), lesquels sont disposés l'un à côté de l'autre et sont accouplés en un mode d'entraînement en tête-bêche par un organe d'accouplement (101), comprenant les étapes suivantes :
prévision (200) d'une première barre d'entraînement (113) qui est disposée le long du premier élément de Coriolis (110) et qui est accouplée au premier élément de Coriolis (110) par le biais d'un premier ressort (114) ;
prévision (202) d'un premier porte-électrodes d'entraînement (136, 137) qui porte une pluralité de premières électrodes d'entraînement (138, 139) s'étendant parallèlement à la première barre d'entraînement (113) ; et
excitation (208) d'une première pluralité d'électrodes statiques, qui s'engrènent avec les premières électrodes d'entraînement afin d'entraîner le premier et le deuxième élément de Coriolis (110, 120) dans le mode d'entraînement en tête-bêche ;
**caractérisé en ce que**
le premier porte-électrodes d'entraînement (136, 137) s'étend depuis la première barre d'entraînement (113) dans la direction opposée au premier élément de Coriolis (110) .

9. Procédé selon la revendication 8, comprenant en outre les étapes suivantes :
prévision (204) d'une deuxième barre d'entraînement (123) qui est disposée parallèlement à la première barre d'entraînement (113) le long du côté du deuxième élément de Coriolis (120) à l'opposé du premier élément de Coriolis (110) et est accouplée au deuxième élément de Coriolis (120) par le biais d'un deuxième ressort (124) ; et
prévision (206) d'un deuxième porte-électrodes d'entraînement (146, 147) qui s'étend depuis la deuxième barre d'entraînement (123) dans la direction opposée au premier élément de Coriolis (110) et porte une pluralité de deuxièmes électrodes d'entraînement (148, 149) qui s'étendent parallèlement à la deuxième barre d'entraînement (123) ; et
l'étape d'excitation (208) comprenant l'excitation coordonnée d'une deuxième pluralité d'électrodes statiques qui s'engrènent avec les deuxièmes électrodes d'entraînement (138, 139).
